# EUROPEAN PATENT SPECIFICATION

(11) **EP 0 608 012 B1**
(45) Date of publication and mention of the grant of the patent: **30.09.1998**
(21) Application number: 94200022.5
(22) Date of filing: 06.01.1994
(51) Int. Cl.: G11C 11/22

(54) **Processing system with a ferroelectric memory**
Prozessorsystem mit ferroelektrischem Speicher
Système processeur avec une mémoire ferro-électrique

(30) Priority: 12.01.1993 EP 93200068
(43) Date of publication of application: 27.07.1994
(73) Proprietor: Koninklijke Philips Electronics N.V., 5621 BA Eindhoven (NL)
(72) Inventor: Cuppens, Roger, c/o INT. OCTROOIBUREAU B.V., NL-5656 AA Eindhoven (NL)
(74) Representative: de Haas, Laurens Johan

(56) References cited:
- EP-A- 0 278 167
- GB-A- 2 107 544
- US-A- 4 599 709
- US-A- 5 086 412

## Description

The invention relates to a processing system as set forth in the precharacterizing part of Claim 1. Such a system is known from US patent No. 5,086,412.

A ferroelectric memory contains ferroelectric capacitors containing ferroelectric material between their plates. A bit of information is represented in this ferroelectric memory as an amount of remanent polarization of the ferroelectric material. Reading and writing of such a bit involves supplying a voltage pulse across the plates of the capacitor. This pulse is supplied to the memory via a bitline connection and a plateline connection.

The known memory comprises identical memory cells organized in rows and columns. Peripheral access circuits are provided to access one row at a time. All cells in each row have the same connection to the periphery of the matrix and all cells in each column have the same connection to the peripheral access circuits of the matrix. When a row is accessed a pulse is supplied to first terminals, the memory cells in the row are connected to respective bitlines and a pulse is applied to second terminals, all memory cells in the row are connected to a common plate line.

Thus all cells in a row will be accessed even if information is needed only from a small number of the cells. This leads to unnecessary fatigue in the ferroelectric capacitors.

From European patent application No EP-A 0359404 a ferroelectric memory is known, in which the memory cells in a column are connected in common to a bitline and a plateline. In order to access only the capacitor in one of these units at a time, the known memory provides for a row select line. By using this row select line, access may be restricted to a unit from one row at a time by the selective activation of first and second switching element in the units in one row.

EP-A 0359404 teaches the use of two switching elements in a unit, connected respectively between the bitline and a first plate of the capacitor and the plateline and a second plate of the capacitor. The use of two switching elements prevents both that a pulse current occurs via the ferroelectric capacitor when the unit is not selected, and also that a pulse voltage is supplied to either plate of the ferroelectric capacitor; no matter whether such a pulse occurs on the plateline connection or on the bitline connection of the unit.

This substantially prevents parasitic disturbance of the polarization on the capacitors in unselected units. However, the prior art memory has the disadvantage that it achieves this effect by using twice as many switching elements as there are capacitors, which constitutes a large amount of overhead for a memory circuit.

It is an object of the invention to provide for a processing system with a ferroelectric memory in which pulses across the plates of ferroelectric capacitors in unselected units are substantially prevented, without requiring two switching elements per capacitor.

It is a further object of the invention to increase the average speed of access to the capacitors.

The system according to the invention is characterized by the characterizing part of Claim 1. Thus, each row is divided into a number of units. Each unit stores an N bit word and needs only N+1 switching elements. Typical word sizes in the processing unit are small multiple of eight bits, for example N=8, 16 or 32. Therefore preferably the number of serial arrangements in each unit in the system according to the invention is the same multiple of eight. In this way the various bits of a word are concentrated in a single memory unit and not distributed over different memory matrices (which could possibly even require different integrated circuits). The invention is also set forth in claim 7.

In an embodiment of the system according to the invention the processing unit is coupled to an enable input and an address input of the access means, for sending an access enable signal in combination with an address of a particular column, the access means being arranged for supplying an access pulse on the plateline of the particular column only upon reception of said access enable signal. Thus a plurality of capacitors from an individual unit can be accessed simultaneously using a single plateline which is designated with the address. Only one drive circuit for selectively supplying the access pulse to this single plateline in response to the access enable signal needs to be provided to access a plurality of capacitors per column.

In a further embodiment of the word oriented processing system according to the invention the pluralities of bitlines are coupled to a plurality of data input/output lines common for all columns via respective pluralities of dataline switching elements provided for respective columns, the access means being arranged for collectively activating only the plurality of dataline switching elements of the accessed column during said access pulse. The data lines and the data line switching elements provide for simultaneous access to the plurality of capacitors.

In an embodiment of the word oriented processing system according to the invention it comprises equalizing means under control of the access means, arranged for mutually equalizing the voltage levels of the respective plateline and the plurality of bitlines in each respective column other than the particular column during said access pulse. A whole row of units has its capacitors connected to its respective platelines and bitlines at a time. By equalizing the unaccessed columns, the disturbance of the polarization on the capacitors in unselected columns due to parasitic coupling is reduced further.

In an embodiment of the word oriented processing system according to the invention the equalization is provided for in that the equalizing means in each column comprise equalizing switching elements, coupled between on one hand a reference voltage node and on the other hand the plateline and respective ones of the plurality of bitlines, the access means being arranged for activating the equalizing switching elements when and only when the dataline switching elements are disactivated. The reference voltage node may for example be at ground potential; with a single control signal the access means can thus control both equalizing and dataline connection.

In an embodiment of the word oriented processing system according to the invention the equalizing means are arranged for mutually equalizing the voltage levels of the respective plateline and the plurality of bitlines in all respective columns between successive access pulses, prior to activations of the switching elements in a row. In this way, it is prevented that charge remaining on the bitlines and plateline after access can disturb the unit in a newly selected row.

It should be noted that from US patent No 4,873,664 a ferroelectric memory is known with two ferroelectric capacitors per memory unit. In contrast to the present invention, these two capacitors are used to store only a single bit differentially in each unit. The access means for this memory are arranged for differential sensing. In contrast to the invention, the access means read only the single bit from the unit. Moreover, all the capacitors of the units in each column of this memory are connected together to a common plateline without the intervention of a second switch.

The present invention also applies to memories in which a multibit word can be read in parallel from pairs of ferroelectric capacitors in the unit by sensing the respective differences in remanent polarizations in capacitors of respective pairs.

The word oriented processing system according to the invention and its advantageous aspects will be further described using Figures, in which:
Figure 1 shows an embodiment of word oriented processing system according to the invention
Figure 2 shows signals used for writing into a ferroelectric memory
Figure 3 shows signals used for reading from a ferroelectric memory

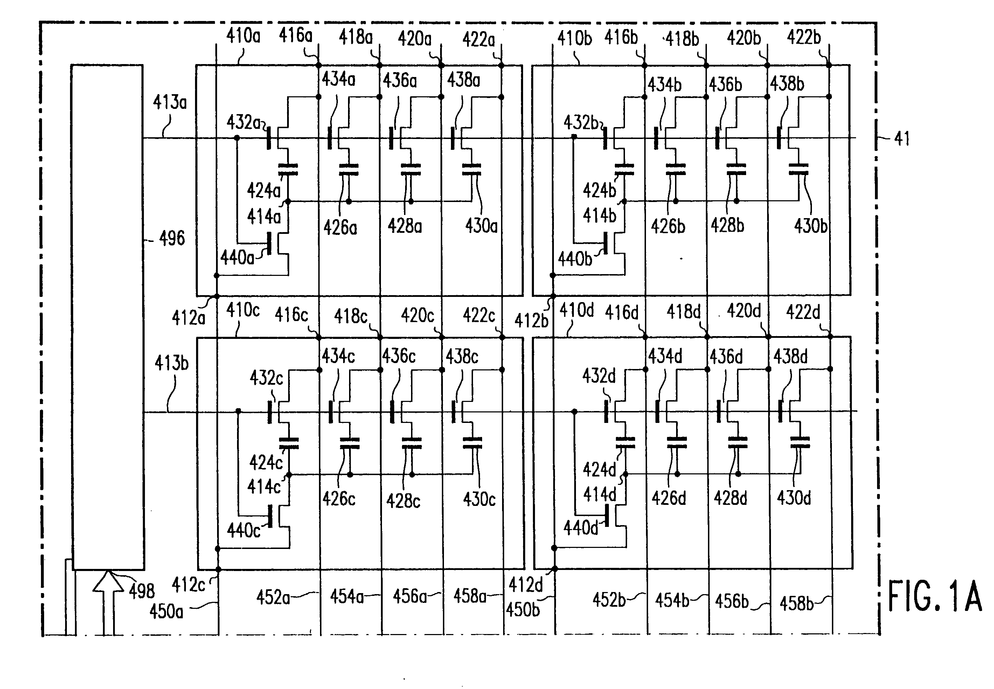

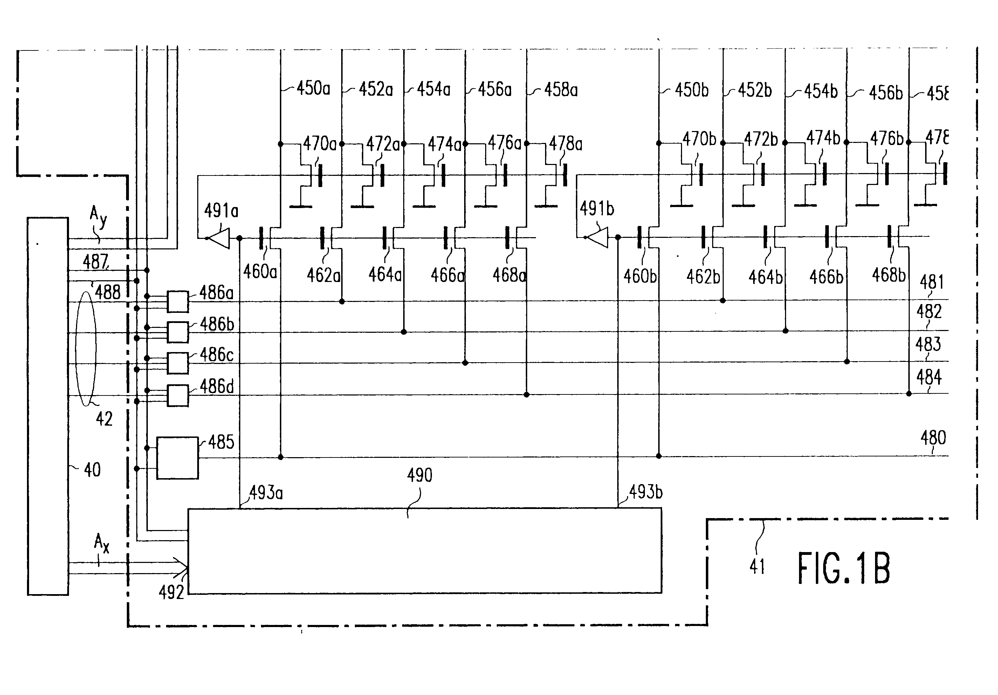

Figure 1 shows an embodiment of a word oriented processing system according to the invention. The system contains a processing unit 40 and a ferroelectric memory 41. The processing unit 40 has an address output Ax, Ay, a data input/output 42 and control outputs coupled to read and write signal lines 487, 488.

The ferroelectric memory 41 contains a number of units 410a, 410b, 410c, 410d, organized in rows and columns. For each column there is one plateline 450a, 450b and a plurality of bitlines 452a,b, 454a,b, 456a,b, 458a,b. Each unit 410a,b,c,d has a plateline connection 412a,b,c,d and a plurality of bitline connections 416a,b,c,d, 418a,b,c,d, 420a,b,c,d, 422a,b,c,d. The bitline connections in each unit 410a,b,c,d are coupled to a common node 414a,b,c,d, in the unit via a respective serial arrangement of the first bitline connection 416a,b,c,d, 418a,b,c,d, 420a,b,c,d, 422a,b,c,d, a respective first switch 432a,b,c,d, 434a,b,c,d, 436a,b,c,d, 438a,b,c,d, and a respective ferroelectric capacitor 424a,b,c,d, 426a,b,c,d, 428a,b,c,d, 430a,b,c,d. The common node 414a,b,c,d is coupled to the plateline connection 412a,b,c,d via a second switch 440a,b,c,d, which is also part of the unit 410a,b,c,d.

The first switches 432a,b,c,d, 434a,b,c,d, 436a,b,c,d, 438a,b,c,d and the second switch 440a,b,c,d are implemented using the channel of insulated gate field effect transistors 432a,b,c,d, 434a,b,c,d, 436a,b,c,d, 438a,b,c,d, 440a,b,c,d. The gates of these transistors 432a,b,c,d, 434a,b,c,d, 436a,b,c,d, 438a,b,c,d, 440a,b,c,d are connected to each other and to an activation input of the unit 410a,b,c,d.

The memory contains a row selection circuit 496. The row selection circuit 496 has an address input 498, for receiving a row address. The row select circuit also has a plurality of row line 413a, 413b outputs. Each row line 413a, 413b is connected to the activation inputs of a row (410a, 410b), (410c, 410d) of memory units.

The platelines 450a, 450b of the columns are coupled to a common plateline 480, via respective switches 460a, 460b. The respective bitlines 452a, 454a, 456a, 458a of each column are connected to respective data lines 481, 482, 483, 484 via respective switches 462a, 462b, 464a, 464b, 466a, 466b, 468a, 468b. The bitlines 452a, 454a, 456a, 458a and the platelines 450a, 450b of each column are coupled to ground via equalizing switches 470a, 472a, 474a, 476a, 478a. The switches 460a, 460b, 462a, 462b, 464a, 464b, 466a, 466b, 468a, 468b, 470a, 472a, 474a, 476a, 478a are implemented as insulated gate field effect transistors.

The memory circuit contains a column select circuit 490, having an input 492 for a column address. The column select circuit 490 has a plurality of column select outputs 493a, 493b coupled to the gates of the transistors 460a, 460b, 462a, 462b, 464a, 464b, 466a, 466b, 468a, 468b coupling the platelines 450a, 450b and the bitlines 452a, 452b, 454a, 454b, 456a, 456b, 458a, 458b to the common plateline 480 and the datalines 481, 482, 483, 484. Each column select outputs 493a, 493b are coupled via inverters 491a, 491b to the gates of the transistors 470a, 470b, 472a, 472b, 474a, 474b, 476a, 476b, 478a, 478b coupling the platelines 470a, 470b and the bitlines 452a, 452b, 454a, 454b, 456a, 456b, 458a, 458b to ground.

The common plateline 480 is coupled to a plateline pulse circuit 485. The plateline pulse circuit 485 has is connected to the read write signal lines enable 487, 488. The data lines 481, 482, 483, 484 are coupled to respective read/write amplifiers 486a, 486b, 486c, 486d. The read write amplifiers 486a, 486b, 486c, 486d are connected to the a read/write signal lines 487, 488.

The processing unit 40 may be for example a microprocessor or a digital signal processor. In operation, the processing unit 40 will address information Ax, Ay to the memory and send or receive data as words containing four bits via the data output 42. (The number of four has been chosen for illustration purposes; any number of bits may be used to make up a word). The processing unit 40 performs operations on the words, such as for example addition. These operations involve all the bits in the words.

To read or write words, a part Ay of the address data is used to control the row selection circuit 496 which, in response, will provide an activation signal on one row line, say 413a, selected from the plurality of row lines 413a, 413b under control from the part Ay of the address received at the address input 498 of the row selection circuit 496. The activation signal will make the first and second switches 432a, 432b, 434a, 434b, 436a, 436b, 438a, 438b, 440a, 440b of the units in one row conductive. The first and second switches 432c, 432d, 434c, 434d, 436c, 436d, 438c, 438d 440c, 440d of the unaddressed rows will not be conductive. The column selection circuit 490 will make the plateline switch 460a and the bitline switches 462a, 464a, 466a, 468a of one column conductive, corresponding to the column address Ax received from the processing unit 40 at the adress input 492 of the column selection circuit 494. The plateline switch 460b and the bitline switches 462b, 464b, 466b, 468b of the unaddressed columns will not be conductive. Consequently, there will be a charge transfer path from the plateline pulsing circuit 485, to the read/write amplifiers 486a, 486b, 486c, 486d via
- the common plateline 480,
- the plateline switching element 460a,
- the plateline 450a for the addressed column,
- the second switch 440a of one unit 410a which is in the addressed row
- the respective ferroelectric capacitors 424a, 426a, 428a, 430a in this unit,
- the respective first switches 432a, 434a, 436a, 438a
- the bitlines 452a, 454a, 456a, 458a of the addressed column,
- the bitline switching elements 462a, 464a, 466a, 468a,
- the data lines 481, 482, 483, 484.

As an alternative, read/write amplifiers 486a, 486b, 486c, 486d may be provided repeatedly, one set for each column. In this case these read/write amplifiers will be located instead of the bitline switches 462a, 464a, 466a, 468a between the bitlines 452a,b 454a,b 456a,b 458a,b and the data lines 480, 481, 482, 483, 484.

Units 410b, 410c, 410d which are either in an unaddressed row 410c, or in an unaddressed column 410b, or both 410d, do not provide such charge transfer paths from the common plateline 480 to the data lines 481, 482, 483, 484.

The operation of the memory unit is based on ferroelectric remanence. Reference is had to US patent No 4,873,664 and its references for a discussion of this effect and for ways of effecting reading and writing information on ferroelectric capacitors. For understanding the system according to the invention it suffices to note the following. A ferroelectric capacitor has two plates, with between them some ferroelectric material. When there is no voltage across the two plates, the ferroelectric material may have either one of two mutually different polarization states. The corresponding polarization is called the remanent polarization, and is non-zero and usually of opposite sign for the two states. The polarization of the ferroelectric material is counteracted by charge on the plates of the capacitors and the charge on the plates depends on the state of the ferroelectric material.

The two different states are used to represent a logic high and logic low information bit stored in the capacitor respectively. Writing is effected by applying a voltage pulse across the plates of the ferroelectric capacitor. The sign of the pulse determines the type of information (logic high or low) written. Reading is also effected by applying a voltage pulse across the plates of the ferroelectric capacitor. In effect this corresponds to writing a predetermined logic level to the capacitor. This involves the transfer of an amount of charge to the plates of the capacitor, the amount depending on whether or not the polarization of the ferroelectric material must be changed. The amount is measured to determine the information previously stored in the capacitor.

Reading destroys the information stored in the capacitor, and may need to be followed by rewriting, when the information must be reused. All reading an writing pulses applied to the capacitor result in fatigue: the amount of remanent polarization that the ferroelectric material can retain, and thereby the noise margin for information storage on the capacitor, decreases with cumulative use.

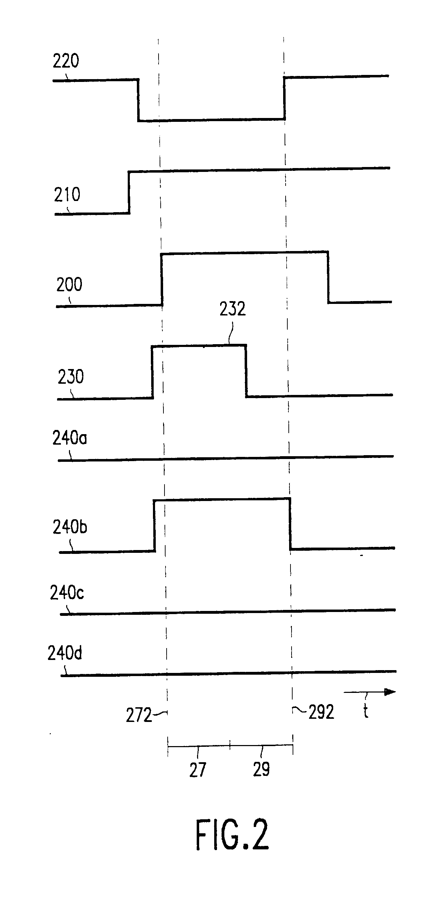

Writing of independent bits of information in the different series arrangements in one unit is effected for example with a pulse method as described for figure 2. In this figure, by way of example, logic levels 0,1,0,0 are written into capacitors 424a, 426a, 428a, 430a respectively.

Figure 2 shows several voltage traces:
- 210: the write control signal on control line 487
- 200: the row select signal on row line 413a
- 220: the signal at the gate of the equalization switches 470a, 472a, 474a, 476a, 478a
- 230: the voltage on the common plateline 480,
- 240a,b,c,d: voltages on the datalines 481, 482, 483, 484,

In discussing figure 2, it will be assumed that one unit 410a is been selected by means of addressing. After transition to their active state 202, 212, the row select signal will make switches 440a,b, 432a,b, 434a,b, 436a,b, 438a,b conductive. The column select signal (the inverse of the equalization signal 220) will make the switches 460a, 462a, 464a, 466a, 468a conductive. The switches 440c,d, 432c,d, 434c,d, 436c,d, 438c,d of the remaining units 410c,d are then non-conductive. The switches 460b, 462b, 464b, 466b, 468b are also non-conductive.

Writing is initiated by the write control signal 210. Writing is effected in a time period indicated by the vertical dashed lines 372, 392 which is composed of two intervals 27, 29. The first interval 27 is started by the row select signal 200. The plateline signal 230 contains a pulse 234 which provides a high voltage on the plateline connection 412a during the first interval 27. The plateline signal 230 is returned to a low voltage during the second interval 29.

A logic high is written in a particular ferroelectric capacitor 426a in the unit 410a. The corresponding read/write circuit 486b ensures that the bitline voltage 240b is at the high value at least during the second interval 29. Thus, there will be a voltage difference across the plates of a selected capacitor 426b, in the second interval 29, the plate on the bitline side being high and the plate on the plateline side being low. Any spurious pulsed voltage differences between the bitline side and the plateline side (due to timing differences between the start of the bitline and plateline signals) is avoided because the row select signal 200 starts later than the plateline signal 230 and the bitline signal 240b.

A logic low is written in the ferroelectric capacitors 424a, 428a, 430a. The corresponding read/write circuits 486a, 486c, 486d ensure that the bitline voltages 240a,c,d are at the low value during the first interval 27 and does not go to the high value in the second interval 29. Thus there will be a voltage difference across the plates of a selected capacitors 424a, 428a, 430a in the first interval 27 only, the plate on the bitline side being low and the plate on the plateline side being high.

The difference between writing a high logic level and a low logic level to individual capacitors 424a, 426a, 428a, 430a is controlled by the voltages 244a,b,c,d placed on the individual datalines 481, 482, 483, 484 by the read/write circuits 486a, 486b, 486c, 486d. A common plateline signal 230 is used for all capacitors 486a, 486b, 486c, 486d in the unit 410a.

After writing all bitlines 452a, 454a, 456a, 458a and the plate line 450a are returned zero voltage before the switches 432a, 434a, 436a, 438a, 440a are made unconductive. This ensures that information is store purely as polarization of the ferroelectric material and not as charge.

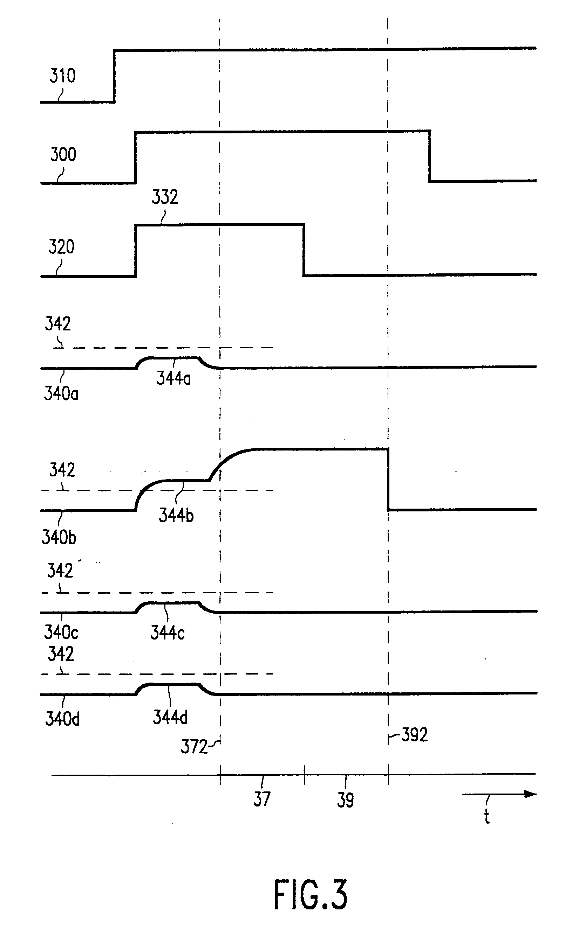

Figure 3 shows an example of signals used in a read operation. The example concerns the same memory unit 410a and the same data 0,1,0,0 as figure 2. The various switches will therefore be in the positions as discussed for figure 2. Figure 3 contains several voltage traces:
- 310: the read control signal on control line 488
- 300: the row select signal on row line 413a
- 320: the signal at the gate of the equalization switches 470a, 472a, 474a, 476a, 478a
- 330: the voltage on the common plateline 480,
- 340a,b,c,d: voltages on the datalines 481, 482, 483, 484,

Reading is initiated by the read control signal 310. Actual reading starts with a pulse 332 applied to the common plateline (and thereby to the plateline 450a of the selected unit 410a) at a time when the voltage 340a, 340b, 340c, 340d on the bitlines 452a, 454a, 456a, 458a is low. The pulse 332 on the plateline 450a will result in a voltage pulse across the plates of the capacitors 424a, 426a, 428a, 430a in the selected unit 410a.

The bits of information stored in the respective capacitors 424a, 426a, 428a, 430a can be measured after the start of the pulse as respective charges transferred to the capacitors via respective bitlines 452a, 454a, 456a, 458a and datalines 481, 482, 483, 484 and the read/write amplifiers 486a, 486b, 486c, 486d. Assuming that the read/write amplifiers 486a, 486b, 486c, 486d represent capacitive loads for the datalines 481, 482, 483, 484 these charges result in residual voltages 344a,b,c,d on the datalines 481, 482, 483, 484. These voltages 344a,b,c,d are shown in traces 340a,b,c,d of figure 2; the voltages 344a,b,c,d are shown smaller than full scale to indicate that they are relatively small residual voltages. The traces are not drawn to scale.

The voltages 344a,b,c,d on the datalines 481, 482, 483, 484 will be relatively high or low with respect to a reference level 342, according to the amount of polarization originally stored on a respective ferroelectric capacitor 424a, 426a, 428a, 430a. In figure 2, by way of example these logic levels are 0,1,0,0 for the capacitors 424a, 426a, 428a, 430a respectively.

After the voltages 344a,b,c,d have started developing, the read/write circuit 486a, 486b, 486c, 486d are activated to amplify these signals. This causes the bitline voltage 340a,b,c,d to move to logic high 340b or low 340a,c,d depending on whether the bitline voltage was above or below the reference level 342. The information read can then be read from the datalines and be supplied to the processing unit 40 via the data input/output 42.

After the voltages 344a,b,c,d have reached the logic level (to the right of the vertical dashed line 372) a write back operation is executed which lasts until the second vertical dashed line 392. Writeback occurs in two intervals time 37, 39 and is analogous to a normal write operation as described using figure 2.

The procedure for reading and writing bis of information which described is one example of how reading an writing may be effected in a ferroelectric memory. Reference is had to US patent No 4,873,664 and its references for other ways of effecting reading and writing.

Also, the read and write control signals 210, 310 on read/write control lines 487, 488 have been used for explanation purposes. In practical use, control may involve other control lines, like chip enable, write enable and output enable. By signals on these lines, possibly in combination with the detection of address changes, the start of read and write will be triggered.

The plateline pulse 232, 332 as shown in figures 2 and 3 is supplied only to the capacitors 424a, 426a, 428a, 430a, in the addressed unit 410a. The plateline pulse is not supplied to the capacitors the other units 410b, 410c, 410d
- because they are in a column which is disconnected from the common plate line 480 by the plateline switch 460b,
- and/or because they are in an unselected row for which the first and second switches 432c, 432d, 434c, 434d, 436c, 436d, 438c, 438d, 440c, 440d are unconductive.

Reading and writing is therefore limited to one unit at a time.

It has been found that a change in the voltage across the plates of a ferroelectric capacitor and a current through the ferroelectric capacitor can disturb the polarization state of the ferroelectric capacitor, even when this change in voltage or this current is small.

Because the plateline pulse is not supplied to the unselected units 410b, 410c, 410d via any conductive path, there will be substantially no pulse voltage on the plates of the unselected ferroelectric capacitors 424b, 424c, 424d, 426b, 426c, 426d, 428b, 428c, 428d, 430b, 430c, 430d. Consequently, there is no risk of a voltage developing across the plates of the unselected ferroelectric capacitors 424b, 424c, 424d, 426b, 426c, 426d, 428b, 428c, 428d, 430b, 430c, 430d. Disturbance of the polarization state of the capacitor is therefore avoided.

Under some circumstances, parasitic coupling from the common plate line 480 to the unselected plate lines 450b may occur even when the plateline switch 460b is not conductive. This may be due for example to capacitive coupling between the common plateline 480 and the unselected platelines 450b. Similarly, and independently, parasitic coupling may occur from the data lines 481, 482, 483, 484 to the unselected bit lines 452b, 454b, 456b, 458b.

Due to such parasitic couplings there may still be a residual pulse even on the unselected platelines 450b and/or the unselected bitlines 452b, 454b, 456b, 458b. Such a residual pulse may give rise to voltage pulses across the plates of the capacitors 424b, 426b, 428b, 430b in units 410b which are in unselected columns but in the row of the selected unit 410a.

As explained hereinbefore these pulses are undesirable. The undesirable pulses may be prevented by providing equalizing switches 470a, 470b, 472a, 472b, 474a, 474b, 476a, 476b, 478a, 478b for all columns. In operation, the plateline 450b and the bitlines 452b, 454b, 456b, 458b of the unselected columns are connected to an equalizing potential, for example ground potential, to prevent the undesired pulses from developing. As an alternative the bitlines 452b, 454b, 456b, 458b of the unselected columns may be connected to the plateline 450b of the unselected column; this will also prevent pulses across the capacitors 424a, 424b, 424c, 424d of the unselected units 410b.

To prevent any undesired pulses from reaching the capacitors in the units 410a, 410b, 410c, 410d all bitlines 452a, 452b, 454a, 454b, 456a, 456b, 458a, 458b are preferably kept equalized with their corresponding platelines 450a, 450b when no access is desired. That is, the equalizing switches 470a, 470b, 472a, 472b, 474a, 474b, 476a, 476b, 478a, 478b are preferably kept conductive until a read write pulse needs to be supplied to the unit 410a, 410b, 410c, 410d via the plateline 450a, 450b.

During access, selection of the column should not change from one column to another. The same goes for selection the rows. This may be achieved by using the access enable signal for example to latch the addresses in the row 498 and column selection circuit 490, in order to prevent such changes.

Even when there are no parasitic couplings, it is desirable that the equalizing switches 470a, 472a, 474a, 476a, 478a are made conductive at least after a unit 410a is accessed. This is advantageous when subsequently a unit 410d in another column and row is accessed. Equalization in this case prevents that any potential level due to charge remaining on the bitlines 452a, 454a, 456a, 458a of the column of the lately accessed unit influence another unit 410c in the newly selected row. Such equalization may be achieved for example by rendering all columns temporarily unselected after access to a memory unit.

From the figures and the description it will be clear that parasitic access pulses on ferroelectric capacitors may be generally prevented using memory units for the storage of multiple bits. For an N bit unit this is achieved using N first switches 432a,b,c,d, 434a,b,c,d, 436a,b,c,d, 438a,b,c,d and one second switch per unit 410a, 410b, 410c, 410d. For the purpose of illustration 4 bit units 410a, 410b, 410c, 410d have been shown, but the invention may of course be applied to units with any number of bits greater than one. Typical numbers are for example 8 bits, 16 bit or 32 bit words (or slightly larger words, for example if additional parity bits are included in order to be able to detect and/or correct memory errors).

Furthermore, it is not necessary that the number of bits in the units corresponds to the full word size of the processing units. An integer divisor of the full word size may also be used (e.g for a 32 bit word size, one may use 32/4=8 or 32/2=16 bit units). Also it is not necessary to transport the bits in parallel to the processor. Instead, for example, after being read in parallel from the memory unit, the bits may be transported to the processing unit 40 in series. The processing unit 40 and the memory 41 may be provided together in a single integrated circuit or they may be provided in separate integrated circuits on an circuit carrier like a printed circuit board.

Furthermore, the invention is not limited to systems with memory units with only one capacitor per bit. One may also use a pair of capacitors per bit. In this case each memory unit will contain a plurality of such pairs, with per unit a common switch connected to one plate of all capacitors in the unit and individual switches connected to the other plate of the capacitors in the unit.

As shown in the figures, the memory can be implemented using MOS transistor switches as switching elements. Instead of MOS transistors, bipolar transistors may be used. The semiconductor used may be silicon, or other, like GaAs. Without deviating from the invention, one may even selectively replace some of the MOS switches by two terminal non-linear devices, such as a Zener diodes or MIM (metal insulator metal) elements. Such devices become conductive when a voltage placed across their terminals exceeds a threshold value. In a unit 410a, either the second switch 440a, or the first switches 432a, 434a, 436a, 438a (but not both) may be replaced by such non linear devices, which need not be connected to the row line 413a. In operation the switching element 440a or all of the switching element 432a, 434a, 436a, 438a, whichever has not been replaced by a two terminal non linear device, is made conductive by a signal via the row line. A sufficiently high potential difference provided between the plateline 450a and bitlines 452a, 454a, 456a, 458a during access will cause a voltage exceeding the threshold of the non linear device across the terminals of this device. The non linear device then becomes conductive, providing a charge transfer path to the capacitors 424a, 426a, 428a, 430a.

## Claims

1. A processing system comprising a ferro-electric memory (41) which is organized in a matrix containing a column of n identical memory units (410a-d), the memory (41) comprising a plateline (450a,b) for conducting an access pulse, each memory unit (410a-d) comprising a plurality of series arrangements (416a-d, 418a-d, 420a-d, 422a-d, 432a-d, 434a-d, 436a-d, 438a-d, 424a-d, 426a-d, 428a-d, 430a-d, 440a-d) each connected between a different bitline connection (416a-d, 418a-d, 430a-d, 422a-d) and said plateline (450a-b) each series arrangement (416a-d, 418a-d, 420a-d, 422a-d, 432a-d, 434a-d, 436a-d, 438a-d, 424a-d, 426a-d, 428a-d, 430a-d, 440a-d) comprising successively the bit line connection (416a-d, 418a-d, 420a-d, 422a-d), a first switching element (432a-d, 434a-d, 436a-d, 438a-d), a ferroelectric capacitor (424a-d, 426a-d, 428a-d, 430a-d) a second switching element (440a-d) and a plateline connection, the column comprising a set of bitlines (452a-b, 454a-b, 456a-b, 458a-b), that are connected on a one to one basis to the bitline connections (416a-d, 418a-d, 420a-d, 422a-d) of each memory unit (410a-b) in the column, the memory comprising means (490, 496) for activating the first and second switching elements (432a-d, 434a-d, 436a-d, 438a-d, 440a-d) of memory units (410a-d) for establishing a charge transfer path through the memory unit (410a-d), wherein said series arrangements (416a-d, 418a-d, 420a-d, 422a-d, 432a-d, 434a-d, 436a-d, 438a-d, 424a-d, 426a-d, 428a-d, 430a-d, 440a-d) of each memory unit (410a-d) share the second switching element (440a-d), the system comprising access means (490, 496) arranged for writing and/or reading respective information bits of a word as polarization of the respective ferroelectric capacitors (424a-d, 426a-d, 428a-d, 430a-d) in the respective series arrangements (416a-d, 418a-d, 420a-d, 422a-d, 432a-d, 434a-d, 436a-d, 438a-d, 424a-d, 426a-d, 428a-d, 430a-d, 440a-d) in a memory unit (410a-d) which is selected, characterized in that the memory matrix contains m columns identical to said column thereby forming an n x m matrix of said memory units, n and m each being equal to or greater than two, each column having a respective plateline (450a,b), the second switching element (440a-d) of each memory unit (410a-d) in each column being connected between the plateline (450a-b) for that column and the ferroelectric capacitors (424a-d, 426a-d, 428a-d, 430a-d) in that memory unit (410a-d), and in that the processing system comprises a processing unit (40) interfaced to the memory (41), the processing system being word oriented, each memory unit (410a-d) storing a respective word, the processing unit (40) selecting a memory unit (410a-d), the processing system collectively transferring the information bits of the word in said memory unit (410a-d) in parallel between said memory unit (410a-d) and the processing unit (40).

2. A processing system according to Claim 1, characterized, in that the processing unit (40) is coupled to an enable input (487) and an address input (AX, Ay) of the access means (490, 496), for sending an access enable signal in combination with an address of an accessed column, the access means (490, 496) being arranged for supplying the access pulse on the plateline for the accessed column only upon reception of said access enable signal.

3. A processing system according to Claim 2, each bitline (452a-b, 454a-b, 456a-b, 458a-b) being connected to a respective dataline switching element (462a-b, 464a-b, 466a-b, 468a-b), the dataline switching elements (462a-b, 464a-b, 466a-b, 468a-b) in each column being coupled on a one to one basis to a set of data input/output lines (481, 482, 483, 484) common to all columns, the access means (490, 496) being arranged for collectively activating only the dataline switching elements (462a-b, 464a-b, 466a-b, 468a-b) of the accessed column during said access pulse.

4. A processing system according to Claim 2 or 3, characterized, in that it comprises equalizing means (470a-b, 472a-b, 474a-b, 476a-b, 478a-b) under control of the access means (490, 496), arranged for mutually equalizing the voltage levels of the respective plateline (450a-b) and the bitlines (452a-b, 454a-b, 456a-b, 458a-b) in each respective column other than the accessed column during said access pulse.

5. A processing system according to Claim 4, characterized, in that the equalizing means (470a-b, 472a-b, 474a-b, 476a-b, 478a-b) in each column comprise equalizing switching elements (470a-b, 472a-b, 474a-b, 476a-b, 478a-b), coupled between on one hand a reference voltage node and on the other hand the plateline (450a-b) and the bitlines (452a-b, 454a-b, 456a-b, 458a-b) respectively, the access means (490, 496) being arranged for activating the equalizing switching elements (470a-b, 472a-b, 474a-b, 476a-b, 478a-b) in a column when the dataline switching elements (462a-b, 464a-b, 466a-b, 468a-b) in that column are disactivated.

6. A processing system according to Claim 4 or 5, characterized, in that the equalizing means (470a-b, 472a-b, 474a-b, 476a-b, 478a-b) are arranged for mutually equalizing the voltage levels of the respective plateline (450a-b) and the plurality of bitlines (452a-b, 454a-b, 456a-b, 458a-b) in all respective columns between successive access pulses, prior to activations of the first and second switching elements (432a-d, 434a-d, 436a-d, 438a-d, 440a-d) of the memory units (410a-d) in a row.

7. A ferro-electric memory (41) which is organized in a matrix containing a column of n identical memory units (410a-d), the memory (41) comprising a plateline (450a,b) for conducting an access pulse, each memory unit (410a-d) comprising a plurality of series arrangements (416a-d, 418a-d, 420a-d, 422a-d, 432a-d, 434a-d, 436a-d, 438a-d, 424a-d, 426a-d, 428a-d, 430a-d, 440a-d) each connected between a different bitline connection (416a-d, 418a-d, 430a-d, 422a-d) and the plateline (450a-b) each series arrangement (416a-d, 418a-d, 430a-d, 422a-d, 432a-d, 434a-d, 436a-d, 438a-d, 424a-d, 426a-d, 428a-d, 430a-d, 440a-d) comprising successively the bit line connection (416a-d, 418a-d, 420a-d, 422a-d), a first switching element (432a-d, 434a-d, 436a-d, 438a-d), a ferroelectric capacitor (424a-d, 426a-d, 428a-d, 430a-d) a second switching element (440a-d) and a plateline connection, the column comprising a set of bitlines (452a-b, 454a-b, 456a-b, 458a-b), that are connected on a one to one basis to the bitline connections (416a-d, 418a-d, 420a-d, 422a-d) of each memory unit (410a-b) in the column, the memory comprising means (490, 496) for activating the first and second switching elements (432a-d, 434a-d, 436a-d, 438a-d, 440a-d) of memory units (410a-d) for establishing a charge transfer path through the memory unit (410a-d), wherein said series arrangements (416a-d, 418a-d, 420a-d, 422a-d, 432a-d, 434a-d, 436a-d, 438a-d, 424a-d, 426a-d, 428a-d, 430a-d, 440a-d) of each memory unit (410a-d) share the second switching element (440a-d), the system comprising access means (490, 496) arranged for writing and/or reading respective information bits of a word as polarization of the respective ferroelectric capacitors (424a-d, 426a-d, 428a-d, 430a-d) in the respective series arrangements (416a-d, 418a-d, 420a-d, 422a-d, 432a-d, 434a-d, 436a-d, 438a-d, 424a-d, 426a-d, 428a-d, 430a-d, 440a-d) in a memory unit (410a-d) which is selected, characterized in that the memory matrix contains m columns identical to said column thereby forming an n x m matrix of said memory units, n and m each being equal to or greater than two, each column having a respective plateline (450a,b), the second switching element (440a-d) of each memory unit (410a-d) in each column being connected between the plateline (450a-b) for that column and the ferroelectric capacitors (424a-d, 426a-d, 428a-d, 430a-d) in that memory unit (410a-d), and in that the memory being word oriented, each memory unit (410a-d) storing a respective word, the memory collectively transferring the information bits of the word in said memory unit (410a-d) in parallel when a word is selected.

8. A ferroelectric memory according to Claim 7, in that it comprises equalizing means (470a-b, 472a-b, 474a-b, 476a-b, 478a-b) under control of the access means (490, 496), arranged for mutually equalizing the voltage levels of the respective plateline (450a-b) and the bitlines (452a-b, 454a-b, 456a-b, 458a-b) in each respective column other than the accessed column during said access pulse.

9. A ferroelectric memory according to Claim 8, characterized, in that the equalizing means (470a-b, 472a-b, 474a-b, 476a-b, 478a-b) in each column comprise equalizing switching elements (470a-b, 472a-b, 474a-b, 476a-b, 478a-b), coupled between on one hand a reference voltage node and on the other hand the plateline (450a-b) and the bitlines (452a-b, 454a-b, 456a-b, 458a-b) respectively, the access means (490, 496) being arranged for activating the equalizing switching elements (470a-b, 472a-b, 474a-b, 476a-b, 478a-b) in a column when the dataline switching elements (462a-b, 464a-b, 466a-b, 468a-b) in that column are disactivated.

10. A ferroelectric memory according to Claim 8 or 9, characterized, in that the equalizing means (470a-b, 472a-b, 474a-b, 476a-b, 478a-b) are arranged for mutually equalizing the voltage levels of the respective plateline (450a-b) and the plurality of bitlines (452a-b, 454a-b, 456a-b, 458a-b) in all respective columns between successive access pulses, prior to activations of the first and second switching elements (432a-d, 434a-d, 436a-d, 438a-d, 440a-d) of the memory units (410a-d) in a row.

## Patentansprüche

1. Wortorientiertes Prozessorsystem mit einem ferroelektrischen Speicher (41), der in einer Matrix mit einer Spalte identischer Speichereinheiten (410a-d) organisiert ist, wobei der Speicher (41) eine Plattenleitung (450a,b) zum Zuleiten eines Zugriffsimpulses enthält, jede Speichereinheit (410a-d) eine Anzahl von Reihenschaltungen (416a-d, 418a-d, 420a-d, 422a-d, 432a-d, 434a-d, 436a-d, 438a-d, 424a-d, 426a-d, 428a-d, 430a-d, 440a-d) mit je einer Verbindung zwischen einer verschiedenen Bitleitungsverbindung (416a-d, 418a-d, 420a-d, 422a-d) und der Plattenleitung (450a-b) enthält, jede Reihenschaltung (416a-d, 418a-d, 420a-d, 422a-d, 432a-d, 434a-d, 436a-d, 438a-d, 424a-d, 426a-d, 428a-d, 430a-d, 440a-d) aufeinanderfolgend die Bitleitungsverbindung (416a-d, 418a-d, 420a-d, 422a-d), ein erstes Schaltungselement (432a-d, 434a-d, 436a-d, 438a-d), eine ferroelektrischen Kondensator (424a-d, 426a-d, 428a-d, 430a-d), ein zweites Schaltungselement (440a-d) sowie eine Plattenleitungsverbindung enthält, die Spalte einen Satz von Bitleitungen (452a-b, 454a-b, 456a-b, 458a-b) enthält, die auf einer Eins-zu-Eins-Basis mit den Bitleitungsverbindungen (416a-d, 418a-d, 420a-d, 422a-d) jeder Speichereinheit (410a-b) in der Spalte verbunden sind, der Speicher Mittel (490, 496) zum Aktivieren der ersten und zweiten Schaltungselemente (432a-d, 434a-d, 436a-d, 438a-d, 440a-d) von Speicherelementen (410a-d) zum Bereiten eines Ladungsübertragungsweges durch die Speichereinheit (410a-d) enthält, worin die Reihenschaltungen (416a-d, 418a-d, 420a-d, 422a-d, 432a-d, 434a-d, 436a-d, 438a-d, 424a-d, 426a-d, 428a-d, 430a-d, 440a-d) jeder Speichereinheit (410a-d) sich das zweite Schaltungselement (440a-d) teilen, das System Zugriffsmittel (490, 496) zum Schreiben und/oder Lesen jeweiliger Informationsbits eines Wortes als Polarisation der betreffenden ferroelektrischen Kondensatoren (424a-d, 426a-d, 428a-d, 430a-d) in den betreffenden Reihenschaltungen (416a-d, 418a-d, 420a-d, 422a-d, 432a-d, 434a-d, 436a-d, 438a-d, 424a-d, 426a-d, 428a-d, 430a-d, 440a-d) in einer ausgewählten Speichereinheit (410a-d) enthält, dadurch gekennzeichnet, daß die Speichermatrix m Spalten gleich der Spalte enthält, wobei sich eine n x m Matrix der Speichereinheiten bildet, wobei n und m gleich oder größer als zwei sind, jede Spalte eine jeweilige Plattenleitung (450a,b) enthält, das zweite Schaltungselement (440a-d) jeder Speichereinheit (410a-d) in jeder Spalte zwischen der Plattenleitung (450a-b) für diese Spalte und den ferroelektrischen Kondensatoren (424a-d, 426a-d, 428a-d, 430a-d) in dieser Speichereinheit (410a-d) angeschlossen ist, und daß das Prozessorsystem eine Prozessoreinheit (40) als Schnittstelle beim Speicher (41) enthält, wobei das Prozessorsystem wortorientiert wird, jede Speichereinheit (410a-d) ein jeweiliges Wort speichert, die Prozessoreinheit (40) eine Speichereinheit (410a-d) wählt, und das Prozessorsystem kollektiv die Informationsbits des Worts in der Speichereinheit (410a-d) parallel zwischen der Speichereinheit (410a-d) und der Prozessoreinheit (40) überträgt.

2. Prozessorsystem nach Anspruch 1, dadurch gekennzeichnet, daß die Prozessoreinheit (40) mit einem Freigabeeingang (487) und einem Adreßeingang (AX, Ay) des Zugriffsmittels (490, 496) zum Übersenden eines Zugriffsfreigabesignals in Kombination mit einer Adresse einer aufgerufenen Spalte gekoppelt ist, wobei das Zugriffsmittel (490, 496) zum Ausgeben des Zugriffsimpulses auf der Plattenleitung für die adressierte Spalte nur beim Empfang des Zugriffsfreigbaesignals angeordnet ist.

3. Prozessorsystem nach Anspruch 2, dadurch gekennzeichnet, daß jede Bitleitung (452a-b, 454a-b, 456a-b, 458a-b) mit einem jeweiligen Datenleitungsschaltungselement (462a-d, 464a-d, 466a-d, 468a-d) verbunden ist, wobei die Datenleitungs-schaltungselemente (462a-d, 464a-d, 466a-d, 468a-d) in jeder Spalte auf einer Eins-zu-Eins-Basis mit einer für alle Spalten gemeinsamen Gruppe von Dateneingangs/ausgangsleitungen (481, 482, 483, 484) gekoppelt sind, und das Zugriffsmittel (490, 496) zum kollektiven Aktivieren nur der Datenleitungsschaltungselemente (462a-d, 464a-d, 466a-d, 468a-d) der aufgerufenen Spalte während des Zugriffsimpulses angeordnet ist.

4. Prozessorsystem nach Anspruch 2 oder 3, dadurch gekennzeichnet, daß es Ausgleichsmittel (470a-b, 472a-b, 474a-b, 476a-b, 478a-b) unter der Steuerung des Zugriffsmittels (490, 496) in der Anordnung zum gegenseitigen Ausgleichen der Spannungspegel der betreffenden Plattenleitung (450a-b) und der Bitleitungen (452a-b, 454a-b, 456a-b, 458a-b) in jeder betreffenden Spalte anders als der aufgerufenen Spalte während des Zugriffsimpulses enthält.

5. Prozessorsystem nach Anspruch 4, dadurch gekennzeichnet, daß die Ausgleichsmittel (470a-b, 472a-b, 474a-b, 476a-b, 478a-b) in jeder Spalte Ausgleichsschaltungselemente (470a-b, 472a-b, 474a-b, 476a-b, 478a-b) enthalten, die einerseits zwischen einem Bezugsspannungsknotenpunkt und andererseits der Plattenleitung (450a-b) und den Bitleitungen (452a-b, 454a-b, 456a-b, 458a-b) gekoppelt sind, wobei das Zugriffsmittel(490, 496) zum Aktivieren der Ausgleichsschaltungselemente (470a-b, 472a-b, 474a-b, 476a-b, 478a-b) in einer Spalte angeordnet ist, wenn die Datenleitungs-Schaltungselemente (462a-d, 464a-d, 466a-d, 468a-d) in dieser Spalte entaktiviert werden.

6. Prozessorsystem nach Anspruch 4 oder 5, dadurch gekennzeichnet, daß die Ausgleichsmittel (470a-b, 472a-b, 474a-b, 476a-b, 478a-b) zum gegenseitigen Ausgleichen der Spannungspegel der betreffenden Plattenleitung (450a-b) und der Anzahl von Bitleitungen (452a-b, 454a-b, 456a-b, 458a-b) in allen betreffenden Spalten zwischen aufeinanderfolgenden Zugriffsimpulsen vor Aktivierungen der ersten und zweiten Schaltungselemente (432a-d, 434a-d, 436a-d, 438a-d, 440a-d) der Speichereinheiten (410a-d) in einer Zeile angeordnet sind.

7. Ferroelektrischer Speicher (41), der in einer Matrix mit einer Spalte von n identischen Speichereinheiten (410a-d) organisiert ist, wobei der Speicher (41) eine Plattenleitung (450a,b) zum Zuleiten eines Zugriffsimpulses enthält, jede Speichereinheit (410a-d) eine Anzahl von Reihenschaltungen (416a-d, 418a-d, 420a-d, 422a-d, 432a-d, 434a-d, 436a-d, 438a-d, 424a-d, 426a-d, 428a-d, 430a-d, 440a-d) mit je einer Verbindung zwischen einer verschiedenen Bitleitungsverbindung (416a-d, 418a-d, 420a-d, 422a-d) und der Plattenleitung (450a-b) enthält, jede Reihenschaltung (416a-d, 418a-d, 420a-d, 422a-d, 432a-d, 434a-d, 436a-d, 438a-d, 424a-d, 426a-d, 428a-d, 430a-d, 440a-d) aufeinanderfolgend die Bitleitungsverbindung (416a-d, 418a-d, 420a-d, 422a-d), ein erstes Schaltungselement (432a-d, 434a-d, 436a-d, 438a-d), einen ferroelektrischen Kondensator (424a-d, 426a-d, 428a-d, 430a-d), ein zweites Schaltungselement (440a-d) sowie eine Plattenleitungsverbindung enthält, die Spalte einen Satz von Bitleitungen (452a-b, 454a-b, 456a-b, 458a-b) enthält, die auf einer Eins-zu-Eins-Basis mit den Bitleitungsverbindungen (416a-d, 418a-d, 420a-d, 422a-d) jeder Speichereinheit (410a-b) in der Spalte verbunden sind, der Speicher Mittel (490, 496) zum Aktivieren der ersten und zweiten Schaltungselemente (432a-d, 434a-d, 436a-d, 438a-d, 440a-d) von Speicherelementen (410a-d) zum Erzeugen eines Ladungsübertragungsweges durch die Speichereinheit (410a-d) enthält, worin die Reihenschaltungen (416a-d, 418a-d, 420a-d, 422a-d, 432a-d, 434a-d, 436a-d, 438a-d, 424a-d, 426a-d, 428a-d, 430a-d, 440a-d) jeder Speichereinheit (410a-d) sich das zweite Schaltungselement (440a-d) teilen, das System Zugriffsmittel (490, 496) zum Schreiben und/oder Lesen jeweiliger Informationsbits eines Wortes als Polarisation der betreffenden ferroelektrischen Kondensatoren (424a-d, 426a-d, 428a-d, 430a-d) in den betreffenden Reihenschaltungen (416a-d, 418a-d, 420a-d, 422a-d, 432a-d, 434a-d, 436a-d, 438a-d, 424a-d, 426a-d, 428a-d, 430a-d, 440a-d) in einer ausgewählten Speichereinheit (410a-d) enthält, dadurch gekennzeichnet, daß die Speichermatrix m Spalten gleich der Spalte enthält, wobei sich eine n x m Matrix der Speichereinheiten bildet, wobei n und m gleich oder größer als zwei sind, jede Spalte eine jeweilige Plattenleitung (450a,b) enthält, das zweite Schaltungselement (440a-d) jeder Speichereinheit (410a-d) in jeder Spalte zwischen der Plattenleitung (450a-b) für diese Spalte und den ferroelektrischen Kondensatoren (424a-d, 426a-d, 428a-d, 430a-d) in dieser Speichereinheit (410a-d) angeschlossen ist, der Speicher wortorientiert ist, jede Speichereinheit (410a-d) ein jeweiliges Wort speichert, und der Speicher kollektiv die Informationsbits des Wortes in der Speichereinheit (410a-d) bei der Wahl eines Wortes parallel überträgt.

8. Ferroelektrischer Speicher nach Anspruch 7, worin er Ausgleichsmittel (470a-b, 472a-b, 474a-b, 476a-b, 478a-b) unter der Steuerung des Zugriffsmittels (490, 496) zum gegenseitigen Ausgleichen der Spannungspegel der betreffenden Plattenleitung (450a-b) und der Bitleitungen (452a-b, 454a-b, 456a-b, 458a-b) in jeder betreffenden Spalte anders als der aufgerufenen Spalte während des Zugriffsimpulses enthält.

9. Ferroelektrischer Speicher nach Anspruch 8, dadurch gekennzeichnet, daß die Ausgleichsmittel (470a-b, 472a-b, 474a-b, 476a-b, 478a-b) in jeder Spalte Ausgleichsschaltungselemente (470a-b, 472a-b, 474a-b, 476a-b, 478a-b) enthalten, die einerseits zwischen einem Bezugsspannungsknotenpunkt und andererseits der Plattenleitung (450a-b) und den Bitleitungen (452a-b, 454a-b, 456a-b, 458a-b) gekoppelt sind, wobei das Zugriffsmittel (490, 496) zum Aktivieren der Ausgleichsschaltungselemente (470a-b, 472a-b, 474a-b, 476a-b, 478a-b) in einer Spalte angeordnet wird, wenn die Datenleitungs-Schaltungselemente (462a-d, 464a-d, 466a-d, 468a-d) in dieser Spalte entaktiviert sind.

10. Ferroelektrischer Speicher nach Anspruch 8 oder 9, dadurch gekennzeichnet, daß die Ausgleichsmittel (470a-b, 472a-b, 474a-b, 476a-b, 478a-b) zum gegenseitigen Ausgleichen der Spannungspegel der betreffenden Plattenleitung (450a-b) und der Anzahl von Bitleitungen (452a-b, 454a-b, 456a-b, 458a-b) in allen betreffenden Spalten zwischen aufeinanderfolgenden Zugriffsimpulsen vor Aktivierungen der ersten und zweiten Schaltungselemente (432a-d, 434a-d, 436a-d, 438a-d, 440a-d) der Speichereinheiten (410a-d) in einer Zeile angeordnet sind.

## Revendications

1. Système de traitement comprenant une mémoire ferroélectrique (41) qui est structurée en une matrice contenant une colonne de n unités mémoire identiques (410a-d), la mémoire (41) comprenant une ligne de plaques (450a,b) conduisant une impulsion d'accès, chaque unité mémoire (410a-d) comprenant une pluralité de montages en série (416a-d, 418a-d, 420a-d, 422a-d, 432a-d, 434a-d, 436a-d, 438a-d, 424a-d, 426a-d, 428a-d, 430a-d, 440a-d) connecté chacun entre une connexion de ligne de bits différente (416a-d, 418a-d, 430a-d, 422a-d) et ladite ligne de plaques (450a-b), chaque montage en série (416a-d, 418a-d, 420a-d, 422a-d, 432a-d, 434a-d, 436a-d, 438a-d, 424a-d, 426a-d, 428a-d, 430a-d, 440a-d) comprenant successivement la connexion de lignes de bits (416a-d, 418a-d, 420a-d, 422a-d), un premier élément de commutation (432a-d, 434a-d, 436a-d, 438a-d), un condensateur ferroélectrique (424a-d, 426a-d, 428a-d, 430a-d), un second élément de commutation (440a-d) et une connexion de ligne de plaques; la colonne comprenant un jeu de lignes de bits (452a-b, 454a-b, 456a-b, 458a-b), qui sont connectées sur une base de un à un aux connexions de ligne de bits (416a-d, 418a-d, 420a-d, 422a-d) de chaque unité mémoire (410a-b) dans la colonne, la mémoire comprenant des moyens (490,496) pour activer les premiers et les deuxièmes éléments de commutation (432a-d, 434a-d, 436a-d, 438a-d, 440a-d) des unités mémoire (410a-d) pour établir un trajet de transfert de charge à travers l'unité mémoire (410a-d), dans lequel lesdits montages en série (416a-d, 418a-d, 420a-d, 422a-d, 432a-d, 434a-d, 436a-d, 438a-d, 424a-d, 426a-d, 428a-d, 430a-d, 440a-d) de chaque unité mémoire (410a-d) partagent le deuxième élément de commutation (440a-d), le système comprenant des moyens d'accès (490,496) configurés pour écrire et/ou lire des bits d'information respectifs d'un mot sous la forme d'une polarisation des condensateurs ferroélectriques respectifs (424a-d, 426a-d, 428a-d, 430a-d) dans les montages en série respectifs (416a-d, 418a-d, 420a-d, 422a-d, 432a-d, 434a-d, 436a-d, 438a-d, 424a-d, 426a-d, 428a-d, 430a-d, 440a-d) dans une unité mémoire (410a-d) qui est sélectionnée, caractérisé en ce que la matrice mémoire contient m colonnes identiques à ladite colonne, formant de ce fait une matrice n x m desdites unités mémoire, n et m étant égaux ou supérieurs à deux, chaque colonne ayant une ligne de plaques respective (450a,b), le deuxième élément de commutation (440a-d) de chaque umte mémoire (410a-d) dans chaque colonne étant connecté entre la ligne de plaques (450a-b) pour cette colonne et les condensateurs ferroélectriques (424a-d, 426a-d, 428a-d, 430a-d) dans cette unité mémoire (410a-d), et en ce que le système de traitement comprend une unité de traitement (40) reliée à la mémoire (41), le système de traitement étant à mots, chaque unité mémoire (410a-d) stockant un mot respectif, l'unité de traitement (40) sélectionnant une unité mémoire (410a-d), le système de traitement transférant de manière collective les bits d'information du mot dans ladite unité mémoire (410a-d) en parallèle entre ladite unité mémoire (410a-d) et l'unité de traitement (40).

2. Système de traitement suivant la revendication 1, caractérisé en ce que l'unité de traitement (40) est couplée à une entrée de validation (487) et à une entrée d'adresse (Ax, Ay) des moyens d'accès (490,496) pour envoyer un signal de validation d'accès en combinaison avec une adresse d'une colonne qui a fait l'objet d'un accès, les moyens d'accès (490,496) étant configurés pour n'appliquer l'impulsion d'accès sur la ligne de plaques pour la colonne qui a fait l'objet d'un accès que lors de la réception dudit signal de validation d'accès.

3. Système de traitement suivant la revendication 2, chaque ligne de bits (452a-b, 454a-b, 456a-b, 458a-b) étant connectée à un élément de commutation de ligne de données respectif (462a-b, 464a-b, 466a-b, 468a-b), les éléments de commutation de ligne de données (462a-b, 464a-b, 466a-b, 468a-b) de chaque colonne étant couplés sur une base de un à un jeu de lignes d'entrée/de sortie de données (481, 482, 483, 484) commun à toutes les colonnes, les moyens d'accès (490,496) étant configurés pour n'activer de manière collective que les éléments de commutation de lignes de données (462a-b, 464a-b, 466a-b, 468a-b) de la colonne qui a fait l'objet d'un accès pendant ladite impulsion d'accès.

4. Système de traitement suivant la revendication 2 ou 3, caractérisé en ce qu'il comprend des moyens d'égalisation (470a-b, 472a-b, 474a-b, 476a-b, 478a-b) sous le contrôle des moyens d'accès (490,496), configurés pour mutuellement égaliser les niveaux de tension de la ligne de plaques respective (450a-b) et les lignes de bits (452a-b, 454a-b, 456a-b, 458a-b) dans chaque colonne respective autre que la colonne qui a fait l'objet d'un accès pendant ladite impulsion d'accès.

5. Système de traitement suivant la revendication 4, caractérisé en ce que les moyens d'égalisation (470a-b, 472a-b, 474a-b, 476a-b, 478a-b) dans chaque colonne comprennent des elements de commutation d'égalisation (470a-b, 472a-b, 474a-b, 476a-b, 478a-b), couplés entre, d'une part, un noeud de tension de référence et, d'autre part, la ligne de plaques (450a-b) et les lignes de bits (452a-b, 454a-b, 456a-b, 458a-b) respectivement, les moyens d'accès (490,496) étant configurés pour activer les éléments de commutation d'égalisation (470a-b, 472a-b, 474a-b, 476a-b, 478a-b) dans une colonne lorsque les éléments de commutation de ligne de données (462a-b, 464a-b, 466a-b, 468a-b) dans cette colonne sont désactivés.

6. Système de traitement suivant la revendication 4 ou 5, caractérisé en ce que les moyens d'égalisation (470a-b, 472a-b, 474a-b, 476a-b, 478a-b) sont configurés pour mutuellement égaliser les niveaux de tension de la ligne de plaques respective (450a-b) et la pluralité de lignes de bits (452a-b, 454a-b, 456a-b, 458a-b) dans toutes les colonnes respectives entre des impulsions d'accès respectives, avant activation des premiers et des deuxièmes éléments de commutation (432a-d, 434a-d, 436a-d, 438a-d, 440a-d) des unités mémoire (410a-d) dans une rangée.

7. Mémoire ferroélectrique (41) qui est structurée en une matrice contenant une colonne de n unités mémoire identiques (410a-d), la mémoire (41) comprenant une ligne de plaques (450a,b) pour conduire une impulsion d'accès, chaque unité mémoire (410a-d) comprenant une pluralité de montages en série (416a-d, 418a-d, 420a-d, 422a-d, 432a-d, 434a-d, 436a-d, 438a-d, 424a-d, 426a-d, 428a-d, 430a-d, 440a-d) connectés chacun entre une connexion de ligne de bits différente (416a-d, 418a-d, 430a-d, 422a-d) et la ligne de plaques (450a-b), chaque montage en série (416a-d, 418a-d, 430a-d, 422a-d, 432a-d, 434a-d, 436a-d, 438a-d, 424a-d, 426a-d, 428a-d, 430a-d, 440a-d) comprenant successivement la connexion de ligne de bits (416a-d, 418a-d, 420a-d, 422a-d), un premier élément de commutation (432a-d, 434a-d, 436a-d, 438a-d), un condensateur ferroélectrique (424a-d, 426a-d, 428a-d, 430a-d), un deuxième élément de commutation (440a-d) et une connexion de ligne de plaques, la colonne comprenant un jeu de lignes de bits (452a-b, 454a-b, 456a-b, 458a-b), qui sont connectées sur une base de un à un aux connexions de ligne de bits (416a-d, 418a-d, 420a-d, 422a-d) de chaque unité mémoire (410a-b) dans la colonne, la mémoire comprenant des moyens (490,496) pour activer les premiers et les deuxièmes éléments de commutation (432a-d, 434a-d, 436a-d, 438a-d, 440a-d) des unités mémoire (410a-d) pour établir un trajet de transfert de charge à travers l'unité mémoire (440a-d), dans laquelle lesdits montages en série (416a-d, 418a-d, 420a-d, 422a-d, 432a-d, 434a-d, 436a-d, 438a-d, 424a-d, 426a,d 428a-d, 430a-d, 440a-d) de chaque unité mémoire (410a-d) partagent le deuxième élément de commutation (440a-d), le système comprenant des moyens d'accès (490,496) configurés pour écrire et/ou lire des bits d'information respectifs d'un mot sous la forme d'une polarisation des condensateurs ferroélectriques respectifs (424a-d, 426a-d, 428a-d, 430a-d) dans les montages en série respectifs (416a-d, 418a-d, 420a-d, 422a-d, 432a-d, 434a-d, 436a-d, 438a-d, 424a-d, 426a-d, 428a-d, 430a-d, 440a-d) dans une unité mémoire (410a-d) qui est sélectionnée, caractérisée en ce que la matrice mémoire contient m colonnes identiques à ladite colonne, formant de ce fait une matrice n x m desdites unités mémoire, n et m étant égaux à deux ou supérieurs à deux, chaque colonne ayant une ligne de plaques respective (450a,b), le deuxième élément de commutation (440a-d) de chaque unité mémoire (410a-d) dans chaque colonne étant connecté entre la ligne de plaques (450a-b) pour cette colonne et les condensateurs ferroélectriques (424a-d, 426a-d, 428a-d, 430a-d) dans cette unité mémoire (410a-d), et en ce que la mémoire étant à mots, chaque unité mémoire (410a-d) stockant un mot respectif, la mémoire transférant de manière collective les bits d'information du mot dans ladite unité mémoire (410a-d) en parallèle lorsqu'un mot est sélectionné.

8. Mémoire ferroélectrique suivant la revendication 7, caractérisée en ce qu'elle comprend des moyens d'égalisation (470a-b, 472a-b, 474a-b, 476a-b, 478a-b) sous contrôle des moyens d'accès (490,496), configurés pour égaliser mutuellement les niveaux de tension de la ligne de plaques respective (450a-b) et les lignes de bits (452a-b, 454a-b, 456a-b, 458a-b) dans chaque colonne respective autre que la colonne qui a fait l'objet d'un accès pendant ladite impulsion d'accès.

9. Mémoire ferroélectrique suivant la revendication 8, caractérisée en ce que les moyens d'égalisation (470a-b, 472a-b, 474a-b, 476a-b, 478a-b) de chaque colonne comprennent des éléments de commutation d'égalisation (470a-b, 472a-b, 474a-b, 476a-b, 478a-b), couplés entre, d'une part, un noeud de tension de référence et, d'autre part, la ligne de plaques (450a-b) et les lignes de bits (452a-b, 454a-b, 456a-b, 458a-b) respectivement, les moyens d'accès (490,496) étant configurés pour activer les éléments de commutation d'égalisation (470a-b, 472a-b, 474a-b, 476a-b, 478a-b) dans une colonne lorsque les éléments de commutation de lignes de données (462a-b, 464a-b, 466a-b, 468a-b) dans cette colonne sont désactivés.

10. Mémoire ferroélectrique suivant la revendication 8 ou 9, caractérisée en ce que les moyens d'égalisation (470a-b, 472a-b, 474a-b, 476a-b, 478a-b) and configurés pour égaliser mutuellement les niveaux de tension de la ligne de plaques (450a-b) respective et la pluralité de lignes de bits (452a-b, 454a-b, 456a-b, 458a-b), dans toutes les colonnes respectives entre des impulsions d'accès successives, avant activation des premiers et des deuxièmes éléments de commutation (432a-d, 434a-d, 436a-d, 438a-d, 440a-d) des unités mémoire (410a-d) dans une rangée.
